(19)

Europäisches Patentamt
European Patent Office
Office européen des brevets

(11) **EP 3 026 718 B1**

(12) **EUROPEAN PATENT SPECIFICATION**

(45) Date of publication and mention of the grant of the patent:
**05.09.2018 Bulletin 2018/36**

(21) Application number: **14830133.6**

(22) Date of filing: **10.07.2014**

(51) Int Cl.:
*H01L 35/14* (2006.01)    *B22F 3/14* (2006.01)
*C01B 33/06* (2006.01)    *C22C 23/00* (2006.01)
*H01L 35/34* (2006.01)    *C22C 1/04* (2006.01)
*C22C 13/00* (2006.01)

(86) International application number:
**PCT/JP2014/068401**

(87) International publication number:
**WO 2015/012113 (29.01.2015 Gazette 2015/04)**

(54) **P-TYPE SEMICONDUCTOR COMPRISING MAGNESIUM, SILICON, TIN, AND GERMANIUM, AND PROCESS FOR PRODUCING SAME**

P-HALBLEITER MIT MAGNESIUM, SILICIUM, ZINN UND GERMANIUM SOWIE VERFAHREN ZUR HERSTELLUNG DAVON

SEMI-CONDUCTEUR DU TYPE P COMPRENANT DU MAGNÉSIUM, DU SILICIUM, DE L'ÉTAIN ET DU GERMANIUM, ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.07.2013 JP 2013154394**

(43) Date of publication of application:
**01.06.2016 Bulletin 2016/22**

(73) Proprietors:
• **National Institute for Materials Science**
  Tsukuba-shi, Ibaraki 305-0047 (JP)
• **Mitsuba Corporation**
  Kiryu-shi, Gunma 376-8555 (JP)

(72) Inventors:
• **ISODA Yukihiro**
  **Tsukuba-shi**
  **Ibaraki 305-0047 (JP)**
• **TADA Satoki**
  **Kiryu-shi**
  **Gunma 376-8555 (JP)**
• **FUJIU Hirofumi**
  **Kiryu-shi**
  **Gunma 376-8555 (JP)**

(74) Representative: **Bennett, Nicholas**
  **Cleveland**
  **10 Fetter Lane**
  **London EC4A 1BR (GB)**

(56) References cited:
    **GB-A- 1 424 011**    **JP-A- 2008 160 077**
    **JP-A- 2009 188 368**    **JP-A- 2010 050 185**

• **GUANGYU JIANG ET AL.: 'Improving p-type thermoelectric performance of Mg2(Ge,Sn) compounds via solid solution and Ag doping' INTERMETALLICS vol. 32, January 2013, pages 312 - 317, XP055310989**
• **FEDOROV, M.I ET AL.: 'Transport properties of Mg2X0.4Sn0.6 solid solutions (X=Si,Ge) with p-type conductivity' PHYSICS OF THE SOLID STATE vol. 48, no. 8, 2006, pages 1486 - 1490, XP019412662**
• **A.U. KHAN ET AL.: 'High thermoelectric figure of merit of Mg2Si0.55Sn0.4Ge0.05 materials doped with Bi and Sb' SCRIPTA MATERIALIA vol. 69, no. 8, 16 July 2013, pages 606 - 609, XP028696495**

## Description

Technical Field

The present invention relates to technical fields of a p-type semiconductor composed of magnesium, silicon, tin, and germanium, and a method for manufacturing the same.

Background Art

Recently, attempts have been made to improve the thermoelectric performance by reducing the resistivity by carrier concentration control by doping a $Mg_2Si$-based material with a p-type dopant (for example, Ag, Ga, or Li). Examples of this are:

- $Mg_2Si$ + 1 at% Ag, ZT = 0.1 (560 K): Refer to Non-Patent Document 1
- $Mg_2Si_{0.6}Ge_{0.4}$ + 0.8% Ga, ZT = 0.36 (625 K): Refer to Non-Patent Document 2
- $Mg_2Si_{0.25}Sn_{0.75}$ + Ag-20000 ppm and Li-5000 ppm, ZT = 0.32 (600 K): Refer to Patent Document 1

Citation List

Non-Patent Documents

Non-Patent Document 1: M. Akasaka et al., J. Appl. Phys., 104, 013703, 2008
Non-Patent Document 2: H. Lhou-Mouko et al., J. Alloys Compd., 509, pp. 6503-6508, 2011

Patent Document

Patent Document 1: Japanese Published Unexamined Patent Application No. 2010-37641
The document GB1424011 discloses how the conductivity of an $Mg_2Si_XGe_YSn_{1-X-Y}$ alloy can be controlled by the addition of a dopant material. The document JP2010050185 discloses a p-type Mg metal compound which includes a Li dopant to obtain excellent electrical conductivity.

Summary of the Invention

Problems to be Solved by the Invention

$Mg_2(SiSn)$ and $Mg_2(SiGe)$ have been studied as promising p-type semiconductors, however, there is no result that is known as having been developed to a practical level. p-type semiconductors $Mg_2(SiSn)$ and $Mg_2(SiGe)$ are solid solutions with $Mg_2Si$, and it is supposed that Ge and Sn contribute to p-type conduction. Therefore, elements that can change the Si site of the base composition must form an anti-fluorite structure with Mg, and such metal elements are limited to silicon (Si), germanium (Ge), tin (Sn), and lead (Pb) of Group 14, however, Pb is excluded since it is a hazardous metal, and an attempt was made to improve the performance of the p-type thermoelectric semiconductor by using the quaternary system:
$Mg_2Si_XSn_YGe_Z$, provided that "X + Y + Z = 1" and "X $\geq$ 0, Y $\geq$ 0, Z $\geq$ 0."
When using ternary $Mg_2SiSn$, only two phase diagrams of $Mg_2Si$ and $Mg_2Sn$ are considered, however, when using the quaternary system, four phase diagrams of $Mg_2Ge$, $Mg_2(SiSn)$, $Mg_2(SiGe)$, and $Mg_2(SnGe)$ must be considered, and preparation itself of a single-phase sample of the quaternary system is difficult, and these are problems that the present invention should solve.

Means for Solving the Problems

In view of the circumstances described above, the present invention was made to solve the above-described problems, and an invention according to Claim 1 provides a method for manufacturing a p-type semiconductor composed of magnesium, silicon, tin, and germanium, represented by the following general chemical formula:
$Mg_2Si_XSn_YGe_Z$, provided that "X + Y + Z = 1" and "X > 0, Y > 0, Z > 0",
the semiconductor is a p-type semiconductor wherein:

X is in the range of $0.00 < X \leq 0.25$, and in this case, Z satisfies the relationship of $-1.00X + 0.40 \geq Z \geq -2.00X + 0.10$, provided that Z > 0.00, and
Y is in the range of $0.60 \leq Y < 0.95$, and in this case, Z satisfies either of the relationships:

- $1.00Y + 1.00 \geq Z \geq -1.00Y + 0.75$, provided that $0.60 \leq Y \leq 0.90$ and Z > 0.00, and

- $2.00Y + 1.90 \geq Z \geq -1.00Y + 0.75$, provided that $0.90 \leq Y < 0.95$ and Z > 0.00, wherein the method comprises the steps of manufacturing a semiconductor by a liquid-solid reaction of magnesium, silicon, tin, and germanium and sintering the product of the reaction.

An invention according to Claim 2 provides a p-type semiconductor composed of magnesium, silicon, tin, and germanium, wherein the semiconductor is made from a sintered compact of an intermetallic compound represented by the following general chemical formula:
$Mg_2Si_XSn_YGe_Z$, provided that "X + Y + Z = 1" and "X > 0, Y > 0, Z > 0",
and the semiconductor is a p-type semiconductor at room temperature wherein:

X is in the range of $0.00 < X \leq 0.25$, and in this case, Z satisfies the relationship:

-    $1.00X + 0.40 \geq Z \geq -2.00X + 0.10$, provided that $Z > 0.00$, and

Y is in the range of $0.60 \leq Y < 0.95$, and in this case, Z satisfies either of the relationships:

-    $1.00Y + 1.00 \geq Z \geq -1.00Y + 0.75$, provided that $0.60 \leq Y \leq 0.90$ and $Z > 0.00$, and
-    $2.00Y + 1.90 \geq Z \geq -1.00Y + 0.75$, provided that $0.90 \leq Y < 0.95$ and $Z > 0.00$.

Effect of the Invention

The inventions according to Claims 1 and 2 make it possible to easily manufacture a semiconductor represented by the following general chemical formula: $Mg_2Si_XSn_YGe_Z$, provided that "X + Y + Z = 1" and "X > 0, Y > 0, Z > 0"
that is effective as a p-type semiconductor.

Brief Description of the Drawings

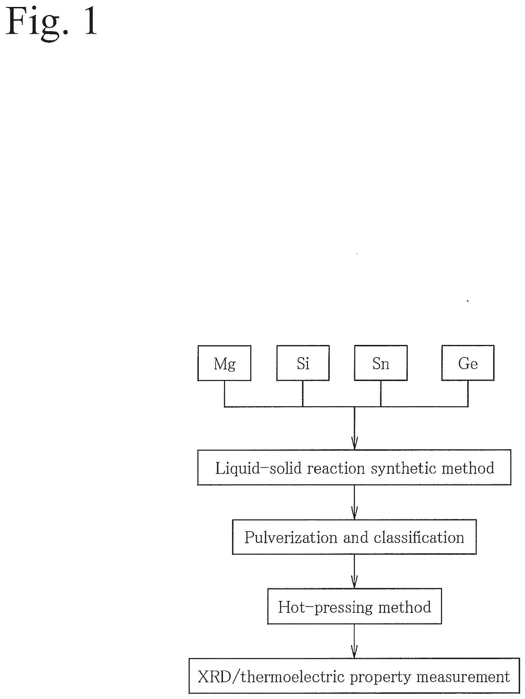

[Fig. 1] Fig. 1 is a process chart for obtaining a semiconductor.
[Figs. 2] Fig. 2A is a table showing compositions of weighed values of semiconductors, and Fig. 2B is a table showing compositions of semiconductors.
[Fig. 3] Fig. 3 is a graph showing X-ray diffraction measurement results of $Mg_2Si_{0.25}Sn_YGe_Z$.
[Fig. 4] Fig. 4 is a table showing the compositions (weighed values) of $Mg_2Si_XSn_YGe_Z$ and thermoelectric properties thereof at a room temperature.
[Figs. 5] Fig. 5A, Fig. 5B, and Fig. 5C are graphs showing the relationships between the Ge composition and the Seebeck coefficient $\alpha$, the thermal conductivity $\kappa$, and the resistivity $\rho$.
[Fig. 6] Fig. 6 is a graph showing the relationship between X and Z.
[Fig. 7] Fig. 7 is a graph showing the relationship between Y and Z.

Mode for Carrying Out the Invention

The present invention provides a p-type semiconductor made of a sintered compact of an intermetallic compound of magnesium (Mg), silicon (Si), tin (Sn), and germanium (Ge), which is represented by the following general chemical formula:
$Mg_2Si_XSn_YGe_Z$, provided that "X + Y + Z = 1" and "X > 0, Y > 0, Z > 0" and first, the sintered compact of the intermetallic compound is manufactured as follows.

As Mg and Sn, granular Mg and Sn with a grain size of approximately 2 to 10 mm are prepared, and as Si and Ge, powdery Si and Ge with a grain size of approximately several tens of $\mu$m are prepared, and predetermined amounts of these materials are weighed and put into a carbon board. The carbon board is covered with a carbon lid, and heated for 4 hours at an absolute temperature of 1173 K under the atmosphere of 0.1 MPa (mega Pascal) Ar (argon)-$H_2$ (3 weight% hydrogen) to cause liquid-solid reaction. The obtained solid solution is pulverized into powder with a grain size of 38 to 75 $\mu$m, and sintered with a hot-pressing. The sintering pressure is standardized to 50 MPa and the sintering time is standardized to 1 hour, and the sintering temperature was determined according to each Sn composition amount Y. The sintering temperature is set to 1190 K when Y = 0, 1040 K when Y = 0.60 or 0.65, and 930 K when Y = 0.75 or 0.90.

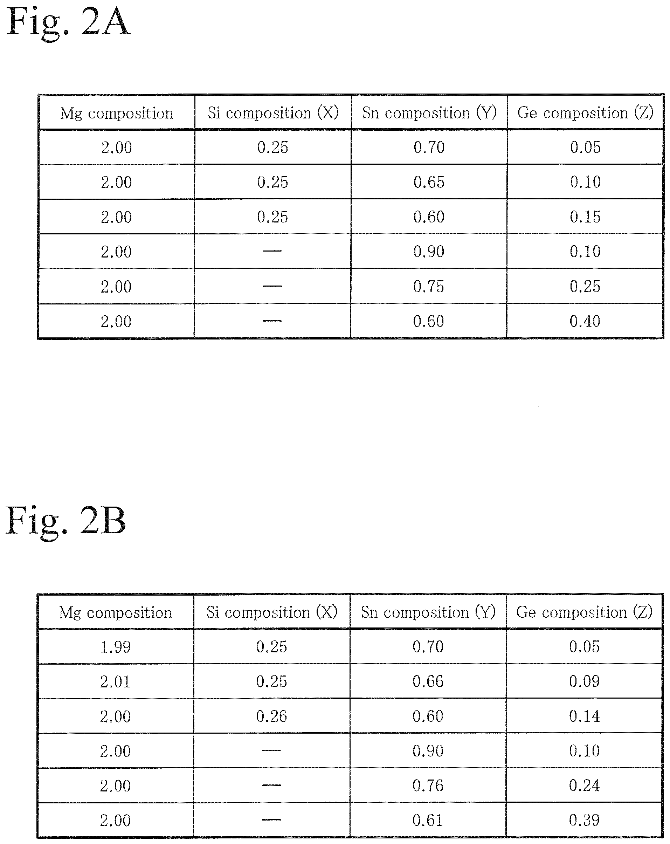

Weighed values (mole ratios) and compositions (mole ratios) of several sintered compacts obtained as described above are shown in the tables of Fig. 2. According to this, the weighed values (Fig. 2A) and the compositions (Fig. 2B) of the sintered compacts are found to have changed little.

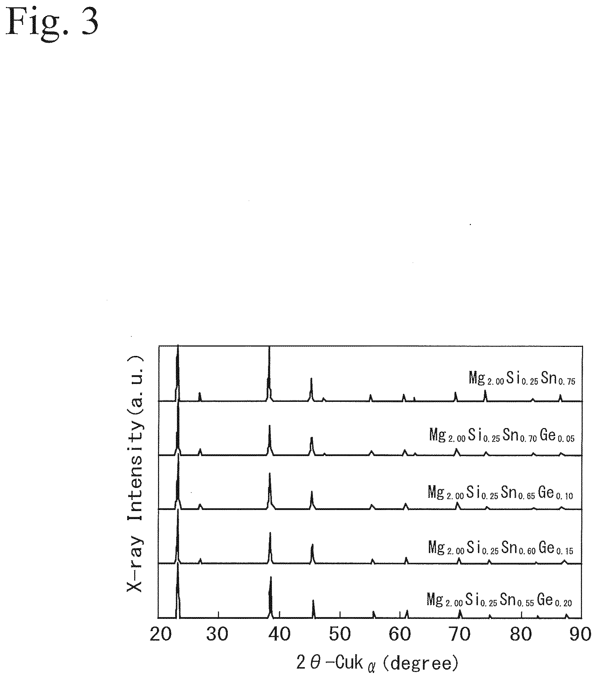

Further, in Fig. 3, results of X-ray diffraction measurement of $Mg_2Si_{0.25}Sn_YGe_Z$ obtained as described above are shown. According to X-ray diffraction, peaks were observed with all of the sintered compacts existing between $Mg_2Si$ and $Mg_2Sn$ with an anti-fluorite structure, and only peaks caused by the anti-fluorite structure were observed, and no peaks were observed with oxides, $Mg_2Si$, $Mg_2Ge$, and $Mg_2Sn$, and from these, it was confirmed that all of the sintered compacts were single-phase. The same results were obtained with other sintered compacts.

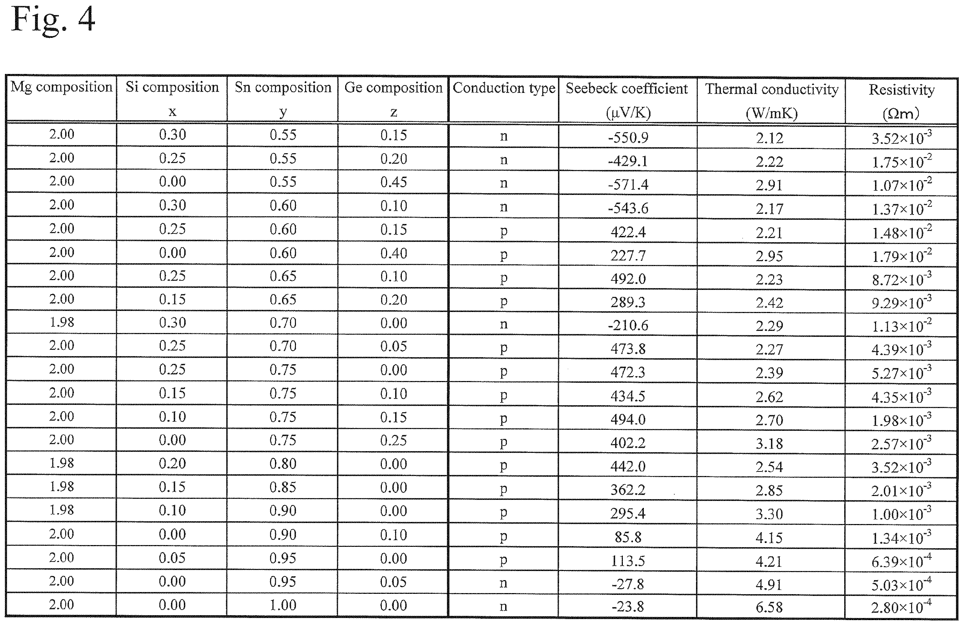

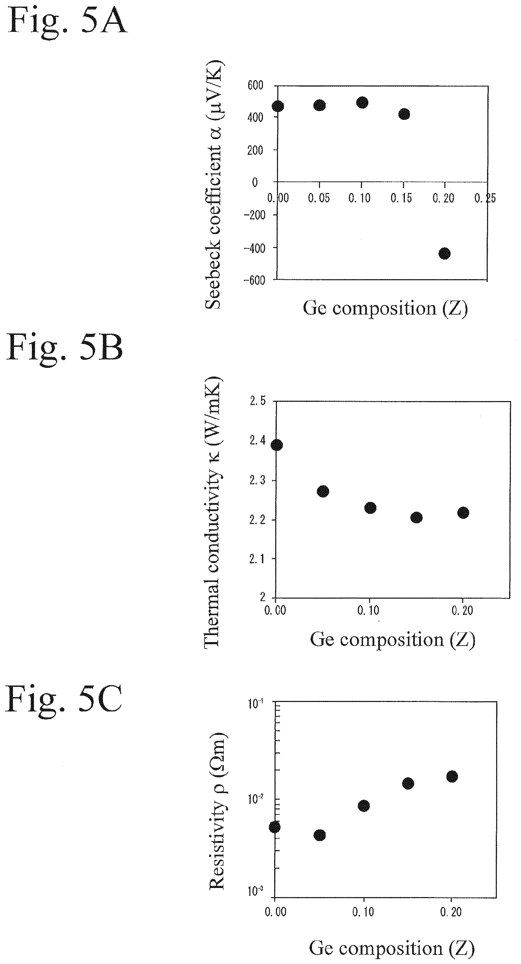

Next, the conduction types, the Seebeck coefficients $\alpha$ ($\mu$V/K), the thermal conductivities $\kappa$ (W/mK), and the resistivities $\rho$ ($\Omega$m) of sintered compacts of $Mg_2Si_XSn_YGe_Z$ thus obtained are shown in the table of Fig. 4. In Fig. 5, graphs showing the relationships between the Ge composition and the Seebeck coefficient $\alpha$, the thermal conductivity $\kappa$, and the resistivity $\rho$ are shown.

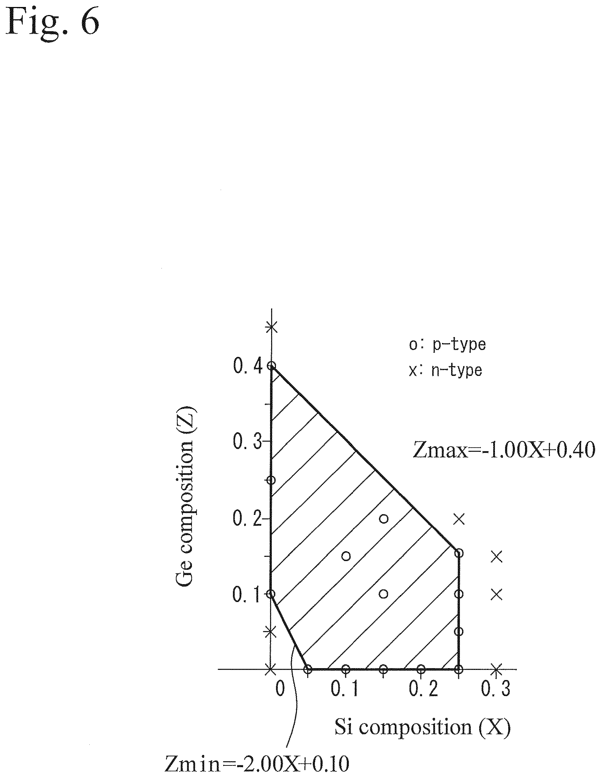

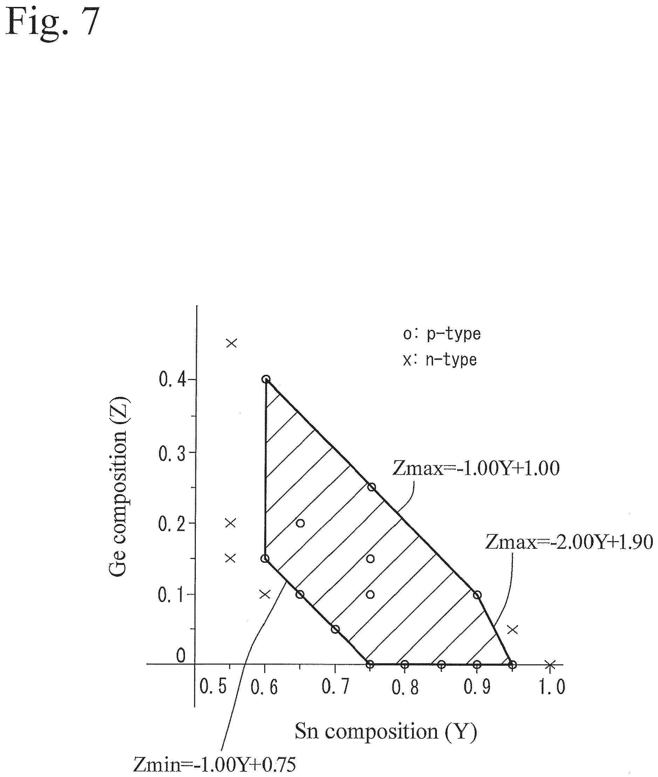

Next, conduction types of the semiconductors when X and Z change based on the results of Fig. 4 are plotted in Fig. 6, and conduction types of the semiconductors when the relationship between Y and Z changes are plotted in Fig. 7. From these graphs, the conduction type border between the p-type and the n-type is found to have changed linearly. In each graph, $\bigcirc$ shows p-type, and $\times$ shows n-type.

First, observing the relationship between X and Z in Fig. 6, as a p-type semiconductor, X is in the range of $0.00 \leq X \leq 0.25$, and when X is in this range, a maximum value $Z_{max}$ and a minimum value $Z_{min}$ of Z for obtaining a p-type semiconductor change linearly in relation to X, and a linear function of $Z_{max}$ and a linear function of $Z_{min}$ are respectively obtained as follows:

$$Z_{max} = -1.00X + 0.40$$

$Z_{min} = -2.00X + 0.10$, provided that $Z_{min} > 0.00$

and it is confirmed that, as a p-type semiconductor, X and Z fall within the shaded range shown in Fig. 6, that is, satisfy the relationship:

- 1.00X + 0.40 ≥ Z ≥ -2.00X + 0.10, provided that Z > 0.00.

Observing the relationship between Y and Z in Fig. 7, as a p-type semiconductor, Y is in the range of $0.60 \leq Y \leq 0.95$, and when Y is in this range, a maximum value $Z_{max}$ and a minimum value $Z_{min}$ of Z for obtaining a p-type semiconductor change linearly in relation to Y, and a linear function of $Z_{max}$ and a linear function of $Z_{min}$ are obtained as follows:

$Z_{max} = -1.00Y + 1.00$, provided that $0.60 \leq Y \leq 0.90$
$Z_{max} = -2.00Y + 1.90$, provided that $0.90 \leq Y \leq 0.95$
$Z_{min} = -1.00Y + 0.75$, provided that $Z_{min} > 0.00$

and it is confirmed that as a p-type semiconductor, Y and Z fall within the shaded range shown in Fig. 7, that is, satisfy the relationship:

- 1.00Y + 1.00 ≥ Z ≥ -1.00Y + 0.75, provided that 0.60 ≤ Y ≤ 0.90 and Z > 0.00,
or
- 2.00Y + 1.90 ≥ Z ≥ -1.00Y + 0.75, provided that 0.90 ≤ Y ≤ 0.95 and Z > 0.00.

Industrial Applicability

The present invention is applicable to obtaining of a p-type semiconductor composed of $Mg_2Si_XSn_YGe_Z$.

Fig. 1

[0021]

　　　Liquid-solid reaction synthetic method
　　　Pulverization and classification
　　　Hot-pressing method
　　　XRD/thermoelectric property measurement

Fig. 2A, 2B

[0022]

　　　Mg composition
　　　Si composition (X)
　　　Sn composition (Y)
　　　Ge composition (Z)

Fig. 4

[0023]

　　　Mg composition

　　　Si composition x
　　　Sn composition y
　　　Ge composition z
　　　Conduction type
　　　Seebeck coefficient (μV/K)
　　　Thermal conductivity (W/mK)
　　　Resistivity (Ωm)

Fig. 5A

[0024]

　　　Seebeck coefficient α (μV/K)
　　　Ge composition (Z)

Fig. 5B

[0025]

　　　Thermal conductivity κ (W/mK)
　　　Ge composition (Z)

Fig. 5C

[0026]

　　　Resistivity ρ (Ωm)
　　　Ge composition (Z)

Fig. 6

[0027]

　　　Ge composition (Z)
　　　Si composition (X)
　　　○: p-type
　　　×: n-type

Fig. 7

[0028]

　　　Ge composition (Z)
　　　Sn composition (Y)
　　　○: p-type
　　　×: n-type

Claims

1. A method for manufacturing a p-type semiconductor composed of magnesium, silicon, tin, and germanium represented by the following general chemical formula:
$Mg_2Si_XSn_YGe_Z$, provided that "X + Y + Z = 1" and "X > 0, Y > 0, Z > 0",
the semiconductor is a p-type semiconductor wherein:

X is in the range of $0.00 < X \leq 0.25$, and in this case, Z satisfies the relationship of $-1.00X + 0.40 \geq Z \geq -2.00X + 0.10$, provided that $Z > 0.00$, and Y is in the range of $0.60 \leq Y < 0.95$, and in this case, Z satisfies either of the relationships:

- $-1.00Y + 1.00 \geq Z \geq -1.00Y + 0.75$, provided that $0.60 \leq Y \leq 0.90$ and $Z > 0.00$, and
- $-2.00Y + 1.90 \geq Z \geq -1.00Y + 0.75$, provided that $0.90 \leq Y < 0.95$ and $Z > 0.00$, wherein

the method comprises the steps of manufacturing a semiconductor by a liquid-solid reaction of magnesium, silicon, tin, and germanium and sintering the product of the reaction.

2. A p-type semiconductor composed of magnesium, silicon, tin, and germanium,
wherein the semiconductor is made from a sintered compact of an intermetallic compound represented by the following general chemical formula:
$Mg_2Si_XSn_YGe_Z$, provided that "$X + Y + Z = 1$" and "$X > 0, Y > 0, Z > 0$",
and the semiconductor is a p-type semiconductor at room temperature wherein:

X is in the range of $0.00 < X \leq 0.25$, and in this case, Z satisfies the relationship:

- $-1.00X + 0.40 \geq Z \geq -2.00X + 0.10$, provided that $Z > 0.00$, and

Y is in the range of $0.60 \leq Y < 0.95$, and in this case, Z satisfies either of the relationships:

- $-1.00Y + 1.00 \geq Z \geq -1.00Y + 0.75$, provided that $0.60 \leq Y \leq 0.90$ and $Z > 0.00$, and
- $-2.00Y + 1.90 \geq Z \geq -1.00Y + 0.75$, provided that $0.90 \leq Y < 0.95$ and $Z > 0.00$.

**Patentansprüche**

1. Verfahren zum Herstellen eines p-Halbleiters, der aus Magnesium, Silicium, Zinn und Germanium besteht, dargestellt durch die folgende allgemeine chemische Formel:
$Mg_2Si_XSn_YGe_Z$, wenn "$X + Y + Z = 1$" und "$X > 0, Y > 0, Z > 0$" sind,
der Halbleiter ist ein p-Halbleiter, wobei:

X im Bereich $0,00 < X \leq 0,25$ ist und in diesem Fall Z die Beziehung

- $-1,00X + 0,40 \geq Z \geq -2,00X + 0,10$ erfüllt, wenn $Z > 0,00$ ist, und

Y im Bereich $0,60 \leq Y < 0,95$ ist und in diesem Fall Z eine der beiden Beziehungen:

- $-1,00Y + 1,00 \geq Z \geq -1,00Y + 0,75$, wenn $0,60 \leq Y \leq 0,90$ und $Z > 0,00$ sind, und
- $-2,00Y + 1,90 \geq Z \geq -1.00Y + 0,75$, wenn $0,90 \leq Y < 0,95$ und $Z > 0,00$ sind, erfüllt, wobei

das Verfahren die Schritte Herstellen eines Halbleiters durch eine Flüssig-Fest-Reaktion von Magnesium, Silicium, Zinn und Germanium und Sintern des Reaktionsproduktes umfasst.

2. p- Halbleiter, der aus Magnesium, Silicium, Zinn und Germanium besteht, wobei der Halbleiter aus einem gesinterten Kompaktkörper aus einer intermetallischen Verbindung hergestellt ist, die durch die folgende allgemeine chemische Formel dargestellt wird:
$Mg_2Si_XSn_YGe_Z$, wenn "$X + Y + Z = 1$" und "$X > 0, Y > 0, Z > 0$" sind,
und der Halbleiter ein p-Halbleiter bei Raumtemperatur ist, wobei

X im Bereich $0,00 < X \leq 0,25$ ist und in diesem Fall Z die Beziehung:

- $-1,00X + 0,40 \geq Z \geq -2,00X + 0,10$ erfüllt, wenn $Z > 0,00$ ist, und

Y im Bereich $0,60 \leq Y < 0,95$ ist und in diesem Fall Z eine der beiden Beziehungen:

- $-1,00Y + 1,00 \geq Z \geq -1,00Y + 0,75$, wenn $0,60 \leq Y \leq 0,90$ und $Z > 0,00$ sind, und
- $-2,00Y + 1,90 \geq Z \geq -1,00Y + 0,75$, wenn $0,90 \leq Y < 0,95$ und $Z > 0,00$ sind, erfüllt.

**Revendications**

1. Procédé de fabrication d'un semi-conducteur de type p composé de magnésium, silicium, étain et germanium représenté par la formule chimique générale suivante :
$Mg_2Si_xSn_yGe_z$, à condition que "$X + Y + Z = 1$" et "$X > 0, Y > 0, Z > 0$",
le semi-conducteur étant un semi-conducteur de type p dans lequel :

X est compris dans la gamme de $0,00 < X \leq 0,25$, et dans ce cas, Z satisfait la relation de $-1,00X + 0,40 \geq Z \geq -2,00X + 0,10$, à condition que $Z > 0,00$, et
Y est compris dans la gamme de $0,60 \leq Y < 0,95$, et dans ce cas, Z satisfait l'une ou l'autre des relations :

- $1{,}00Y + 1{,}00 \geq Z \geq -1{,}00Y + 0{,}75$, à condition que $0{,}60 \leq Y \leq 0{,}90$ et $Z > 0{,}00$, et
- $2{,}00Y + 1{,}90 \geq Z \geq -1{,}00\, Y + 0{,}75$, à condition que $0{,}90 \leq Y < 0{,}95$ et $Z > 0{,}00$,

dans lequel

le procédé comprend les étapes de fabrication d'un semi-conducteur par une réaction liquide-solide de magnésium, silicium, étain, et germanium et de frittage du produit de la réaction.

2. Semi-conducteur de type p composé de magnésium, silicium, étain et germanium, le semi-conducteur étant réalisé à partir d'un compact fritté d'un composé intermétallique représenté par la formule chimique générale suivante :
$Mg_2Si_xSn_yGe_z$, à condition que "$X + Y + Z = 1$" et "$X > 0,\ Y > 0,\ Z > 0$",
le semi-conducteur étant un semi-conducteur de type p à température ambiante dans lequel :

X est compris dans la gamme de $0{,}00 < X \leq 0{,}25$, et dans ce cas, Z satisfait la relation :

- $1{,}00X + 0{,}40 \geq Z \geq -2{,}00X + 0{,}10$, à condition que $Z > 0{,}00$, et

Y est compris dans la gamme de $0{,}60 \leq Y < 0{,}95$, et dans ce cas, Z satisfait l'une ou l'autre des relations :

- $1{,}00Y + 1{,}00 \geq Z \geq -1{,}00Y + 0{,}75$, à condition que $0{,}60 \leq Y \leq 0{,}90$ et $Z > 0{,}00$, et
- $2{,}00Y + 1{,}90 \geq Z \geq -1{,}00\, Y + 0{,}75$, à condition que $0{,}90 \leq Y < 0{,}95$ et $Z > 0{,}00$.

# Fig. 1

```
┌──────┐  ┌──────┐  ┌──────┐  ┌──────┐
│  Mg  │  │  Si  │  │  Sn  │  │  Ge  │
└──────┘  └──────┘  └──────┘  └──────┘
    │         │         │         │
    └─────────┴────┬────┴─────────┘
                   ▼
┌─────────────────────────────────────────┐
│   Liquid-solid reaction synthetic method  │
└─────────────────────────────────────────┘
                   │
                   ▼
     ┌───────────────────────────────┐
     │  Pulverization and classification │
     └───────────────────────────────┘
                   │
                   ▼
       ┌─────────────────────────┐
       │    Hot-pressing method    │
       └─────────────────────────┘
                   │
                   ▼
┌──────────────────────────────────────────────┐
│  XRD/thermoelectric property measurement      │
└──────────────────────────────────────────────┘
```

# Fig. 2A

| Mg composition | Si composition (X) | Sn composition (Y) | Ge composition (Z) |
|---|---|---|---|
| 2.00 | 0.25 | 0.70 | 0.05 |
| 2.00 | 0.25 | 0.65 | 0.10 |
| 2.00 | 0.25 | 0.60 | 0.15 |
| 2.00 | — | 0.90 | 0.10 |
| 2.00 | — | 0.75 | 0.25 |
| 2.00 | — | 0.60 | 0.40 |

# Fig. 2B

| Mg composition | Si composition (X) | Sn composition (Y) | Ge composition (Z) |
|---|---|---|---|
| 1.99 | 0.25 | 0.70 | 0.05 |
| 2.01 | 0.25 | 0.66 | 0.09 |
| 2.00 | 0.26 | 0.60 | 0.14 |
| 2.00 | — | 0.90 | 0.10 |
| 2.00 | — | 0.76 | 0.24 |
| 2.00 | — | 0.61 | 0.39 |

# Fig. 3

X-ray Intensity(a.u.)

$Mg_{2.00}Si_{0.25}Sn_{0.75}$

$Mg_{2.00}Si_{0.25}Sn_{0.70}Ge_{0.05}$

$Mg_{2.00}Si_{0.25}Sn_{0.65}Ge_{0.10}$

$Mg_{2.00}Si_{0.25}Sn_{0.60}Ge_{0.15}$

$Mg_{2.00}Si_{0.25}Sn_{0.55}Ge_{0.20}$

20    30    40    50    60    70    80    90

$2\theta-Cuk_\alpha$ (degree)

# Fig. 4

| Mg composition | Si composition | Sn composition | Ge composition | Conduction type | Seebeck coefficient | Thermal conductivity | Resistivity |
| --- | --- | --- | --- | --- | --- | --- | --- |
| | x | y | z | | ($\mu$V/K) | (W/mK) | ($\Omega$m) |
| 2.00 | 0.30 | 0.55 | 0.15 | n | -550.9 | 2.12 | $3.52 \times 10^{-3}$ |
| 2.00 | 0.25 | 0.55 | 0.20 | n | -429.1 | 2.22 | $1.75 \times 10^{-2}$ |
| 2.00 | 0.00 | 0.55 | 0.45 | n | -571.4 | 2.91 | $1.07 \times 10^{-2}$ |
| 2.00 | 0.30 | 0.60 | 0.10 | n | -543.6 | 2.17 | $1.37 \times 10^{-2}$ |
| 2.00 | 0.25 | 0.60 | 0.15 | p | 422.4 | 2.21 | $1.48 \times 10^{-2}$ |
| 2.00 | 0.00 | 0.60 | 0.40 | p | 227.7 | 2.95 | $1.79 \times 10^{-2}$ |
| 2.00 | 0.25 | 0.65 | 0.10 | p | 492.0 | 2.23 | $8.72 \times 10^{-3}$ |
| 2.00 | 0.15 | 0.65 | 0.20 | p | 289.3 | 2.42 | $9.29 \times 10^{-3}$ |
| 1.98 | 0.30 | 0.70 | 0.00 | n | -210.6 | 2.29 | $1.13 \times 10^{-2}$ |
| 2.00 | 0.25 | 0.70 | 0.05 | p | 473.8 | 2.27 | $4.39 \times 10^{-3}$ |
| 2.00 | 0.25 | 0.75 | 0.00 | p | 472.3 | 2.39 | $5.27 \times 10^{-3}$ |
| 2.00 | 0.15 | 0.75 | 0.10 | p | 434.5 | 2.62 | $4.35 \times 10^{-3}$ |
| 2.00 | 0.10 | 0.75 | 0.15 | p | 494.0 | 2.70 | $1.98 \times 10^{-3}$ |
| 2.00 | 0.00 | 0.75 | 0.25 | p | 402.2 | 3.18 | $2.57 \times 10^{-3}$ |
| 1.98 | 0.20 | 0.80 | 0.00 | p | 442.0 | 2.54 | $3.52 \times 10^{-3}$ |
| 1.98 | 0.15 | 0.85 | 0.00 | p | 362.2 | 2.85 | $2.01 \times 10^{-3}$ |
| 1.98 | 0.10 | 0.90 | 0.00 | p | 295.4 | 3.30 | $1.00 \times 10^{-3}$ |
| 2.00 | 0.00 | 0.90 | 0.10 | p | 85.8 | 4.15 | $1.34 \times 10^{-3}$ |
| 2.00 | 0.05 | 0.95 | 0.00 | p | 113.5 | 4.21 | $6.39 \times 10^{-4}$ |
| 2.00 | 0.00 | 0.95 | 0.05 | n | -27.8 | 4.91 | $5.03 \times 10^{-4}$ |
| 2.00 | 0.00 | 1.00 | 0.00 | n | -23.8 | 6.58 | $2.80 \times 10^{-4}$ |

EP 3 026 718 B1

Fig. 5A

Fig. 5B

Fig. 5C

# Fig. 6

o: p-type
x: n-type

Zmax=-1.00X+0.40

Ge composition (Z)

Si composition (X)

Zmin=-2.00X+0.10

# Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010037641 A
- GB 1424011 A
- JP 2010050185 B

**Non-patent literature cited in the description**

- **M. AKASAKA et al.** *J. Appl. Phys.,* 2008, vol. 104, 013703
- **H. LHOU-MOUKO et al.** *J. Alloys Compd.,* 2011, vol. 509, 6503-6508